# EUROPEAN PATENT SPECIFICATION

(11) **EP 1 657 559 B1**
(45) Date of publication and mention of the grant of the patent: **05.09.2007**
(21) Application number: 06002973.3
(22) Date of filing: 23.01.1998
(51) Int. Cl.: G01R 31/02, G01R 31/12, H02H 3/00

(54) **Method of detecting arcing faults in a line conductor**
Verfahren zur Erfassung von Lichtbogenfehler in einer Übertragungsleitung
Procédé de détection des défauts d'arc dans une ligne de transmission

(30) Priority: 24.01.1997 US 788969; 27.01.1997 US 789659; 04.02.1997 US 794848; 25.03.1997 US 827031; 06.02.1997 US 796745; 11.02.1997 US 799095; 21.02.1997 US 804420; 26.03.1997 US 825005
(43) Date of publication of application: 17.05.2006
(62) Divisional of application: 03008096.4
(73) Proprietor: SQUARE D COMPANY, Palatine, Illinois 60067 (US)
(72) Inventor: Brooks, Stanley J., Richmond KY 40475 (US); Dickens, James W., Lexington KY 40503 (US); Fleege, Dennis W., Cedar Rapids Iowa 52404 (US); Larson, Brett E., Cedar Rapids Iowa 52411 (US); Fixemer, James V., Denton NE 68339 (US); Turner, Dauane L., Cedar Rapids Iowa 52405 (US); Wiese, Gregory S., Marion IA 52302 (US); Dvorak, Robert F., Mr. Vernon Iowa 52314 (US); Haun, Andy A., Cedar Rapids Iowa 52404 (US); Erger, Robert J., Swisher IA 52338 (US); Wong, Kon B., Cedar Rapids Iowa 52404 (US); Bettis, Charles D., Cedar Rapids Iowa 52402 (US)
(74) Representative: Grünecker, Kinkeldey, Stockmair & Schwanhäusser Anwaltssozietät

(56) References cited:
- WO-A-96/35250
- GB-A- 1 215 893
- US-A- 4 466 071
- US-A- 5 434 509
- US-A- 5 561 605

## Description

### FIELD OF THE INVENTION

The present invention relates generally to arcing fault detection systems for protecting an electrical distribution system from arcing faults. More particularly, the present invention relates to an apparatus and method for testing an arcing fault detection system.

### BACKGROUND OF THE INVENTION

Electrical systems in residential, commercial and industrial applications usually include a panelboard for receiving electrical power from a utility source. The power is connected to the panelboard via line bus bars and neutral bus bars. The electrical power is delivered from the panelboard to designated branch circuits through line and neutral conductors supplying one or more loads. Typically, various types of protective devices are mounted to the bus bars of the panelboard to protect the branch circuits from hazardous electrical conditions and reduce the risk of injury, damage or fires.

Circuit breakers are a well known type of protective device which are designed to trip open and interrupt an electric circuit in response to detecting overloads and short circuits. Overload protection is provided by a thermal element which, when heated by the increased current, will cause the circuit breaker to trip and interrupt the power. This can occur when too many loads draw power from the same branch circuit at the same time, or when a single load draws more power than the branch circuit is designed to carry. Short circuit protection is provided by an electromagnetic element that trips when sensing high current flow. Circuit breakers may also provide protection against ground faults which occur when current flows from a hot conductor to ground through a person or object.

Arcing faults, which occur when electric current "arcs" or flows through ionized gas between two ends of a broken conductor, between two conductors supplying a load, or between a conductor and ground, comprise one type of electrical hazard that can not generally be detected by standard circuit breakers. This is because current levels associated with arcing faults are generally not high enough to trip the thermal or electromagnetic elements associated with standard circuit breakers. Arcing faults typically result from corroded, worn or aged wiring or insulation, loose connections, wiring damaged by nails or staples through the insulation, and electrical stress caused by repeated overloading, lightning strikes, etc. The presence of an arcing fault creates a significant fire hazard because it generates heat which may ignite the conductor insulation and adjacent combustible materials.

Arcing fault detection systems known in the an generally sense the current passing through the line conductor of a branch circuit, process the sensed information to determine whether the characteristics of the line current represent the occurrence of an arcing fault, and trip open the branch circuit if an arcing fault has occurred. A preferred arcing fault detection system of this type is described in pending U.S. patent application Serial No. 08/600,512, entitled "Arcing Fault Detection System", assigned to the assignee of the present invention and incorporated herein by reference. The arcing fault detection system may sense line voltage rather than line current.

GB-A-1 215 893 describes a method and apparatus for the automatic measurement of corona inception and extinction in insulated power cables by applying an alternating test voltage whose amplitude steadily increases (or steadily decreases), sampling the first and third quarter cycle of the test voltage for the existence of a corona discharge signal and measuring the test voltage only when the corona discharge signal appears (or disappears) on each of a predetermined plurality of consecutive half cycles of the test voltage.

US-A-5 565 605 specifies an arc detection method using current variation In an electric circuit supplying AC line current to a load from an AC source of given frequency providing repetitive cycles, arc detection is provided by sensing cycle to cycle changes in the AC line current. The AC line current is sampled with a harmonic notch filter at a plurality of n phases ⊖₁ through ⊖ₙ during each of a plurality of m cycles of the AC source, to provide a plurality of currents I_{n,m}, where n is the phase and m is the cycle. The differences (I_{n,m})-(I_{n,m-x}), where x is a designated number of cycles, provide a plurality of current difference signals. The absolute values of these current difference signals are accumulated in a synchronous summer over the m cycles. An arc indicative signal is generated in response to given conditions and given combinations of conditions of the cumulative absolute current difference signals. Cycle to cycle changes in AC line voltage are also sensed with a harmonic notch filter, and the arc indicative signal is disarmed in response to a given voltage condition.

### SUMMARY OF THE INVENTION

In accordance with the present invention, the foregoing objectives are realised as defined in claim 1. Preferred embodiments are defined in the dependent claims.

### BRIEF DESCRIPTION OF THE DRAWINGS

FIG. 1 is a schematic block diagram of an electrical distribution circuit including an arcing fault detection system according to principles of the present invention;
FIG. 2 is an overview flow chart of one manner of operating the arcing fault detection system of FIG. 1;
FIG. 3 is a flow chart illustrating the peak detection subroutine associated with step 2 in the flowchart of FIG. 2;
FIG. 4 is a flow chart illustrating the counting slope changes subroutine associated with step 3 in the flowchart of FIG. 2;
FIG. 5 is a flow chart illustrating the normalization and autocorrelation subroutines associated with step 4 in the flowchart of FIG. 2;
FIG. 6 is a flow chart illustrating the counting shape changes subroutine associated with step 5 in the flowchart of FIG. 2;
FIG. 7 is a flow chart illustrating the check for trip condition subroutine associated with step 6 in the flowchart of FIG. 2;
FIG. 8 depicts the waveforms associated with the detection of slope changes according to one aspect of the present invention; and
FIG. 9 depicts the waveforms associated with the detection of shape changes according to one aspect of the present invention.

### DETAILED DESCRIPTI0N OF SPECIFIC EMBODIMENTS

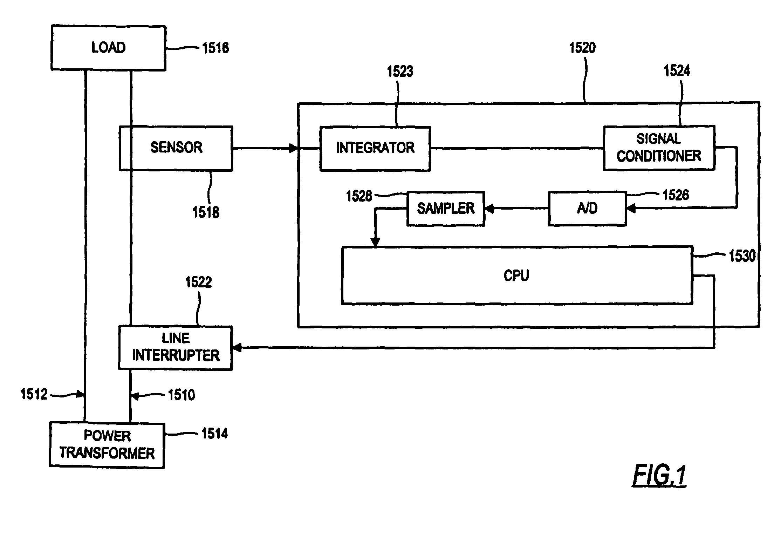

Turning now to the drawings and referring initially to FIG. 1, there is shown a schematic block diagram of an arcing fault detection system connected to a single branch circuit of an electrical distribution system. It will be appreciated, however, that the arcing fault detection system may be connected to multiple branch circuits. Each branch circuit is comprised of line conductor 1510 and neutral conductor 1512 which distribute electrical power from a utility company power transformer 1514 to a load 1516. The line conductor 1510 and neutral conductor 1512 are typically at 240 volts or 120 volts, and a frequency of 60 Hz. A sensor 1518 senses the rate of change of electrical current on the line conductor 1510 and sends a rate-of-change signal, commonly referred to as a di/dt signal, to an arc detector 1520. As will be described in detail hereinafter, the arc detector 1520 processes and evaluates the sensor signal for characteristics of arcing faults. If the arc detector 1520 senses the occurrence of an arcing fault, it produces a trip signal to line interrupter 1522, which interrupts the current in line conductor 1510.

The line interrupter 1522 is preferably a circuit breaker which includes an overload trip mechanism having a thermal/magnetic characteristic which trips the breaker contacts to an open circuit condition in response to a given overload condition, to disconnect the load 1516 from the power source, as is known in the art. It is also known to provide the circuit breaker 1522 with ground fault interrupter circuitry responding to a line or neutral-to-ground fault to energize a trip solenoid which trips the circuit breaker and opens the contacts.

The sensor 1518 preferably comprises a toroidal sensor having an annular core encompassing the current-carrying line conductor 1510, with the sensing coil wound helically on the core. The core is made of magnetic material such as a ferrite, iron, or molded permeable powder capable of responding to rapid changes in flux. A preferred sensor uses a ferrite core wound with 200 turns of 24-36 gauge copper wire to form the sensing coil. An air gap may be cut into the core to reduce the permeability to about 30. The core material preferably does not saturate during the relatively high currents produced by parallel arcs, so that arc detection is still possible at those high current levels.

Other means for sensing the rate of change of the current in a line conductor are contemplated by the present invention. By Faraday's Law, any coil produces a voltage proportional to the rate of change in magnetic flux passing through the coil. The current associated with an arcing fault generates a magnetic flux around the conductor, and the coil of the sensor 1518 intersects this flux to produce a signal. Other suitable sensors include a toroidal transformer with a core of magnetic material or an air core, an inductor or a transformer with a laminated core of magnetic material, and inductors mounted on printed circuit boards. Various configurations for the sensor core are contemplated by the present invention and include toroids which have air gaps in their bodies.

An integrator 1523 integrates the di/dt signal from the sensor 1518 to produce a signal representing the current (i) carried by the line conductor 1510. The integrated di/dt signal (or i signal) is thereafter processed by a signal conditioner 1524 and converted to a series of pulses by analog-to-digital (A/D) converter 1526. The current pulses are then sampled at a plurality of points by sampler 1528. The sampled current is then processed by CPU 1530, which determines the number of certain arcing fault characteristics occurring within a predetermined time interval. If the number of arcing fault characteristics exceed a trip threshold level within the predetermined time interval, the CPU 1530 produces a trip signal to trigger the line interrupter 1522.

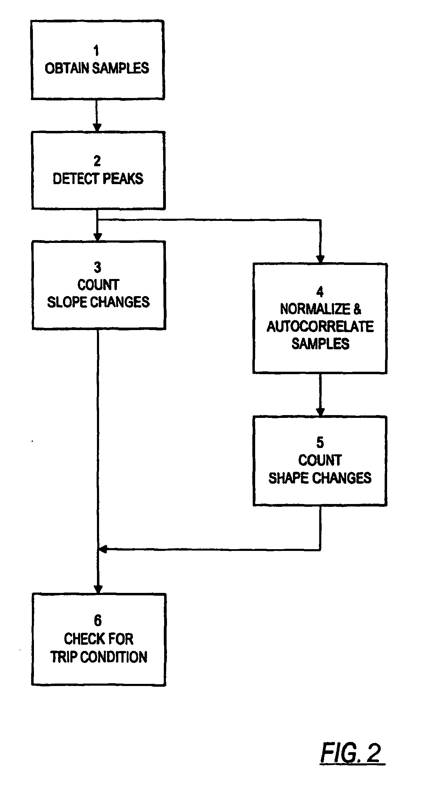

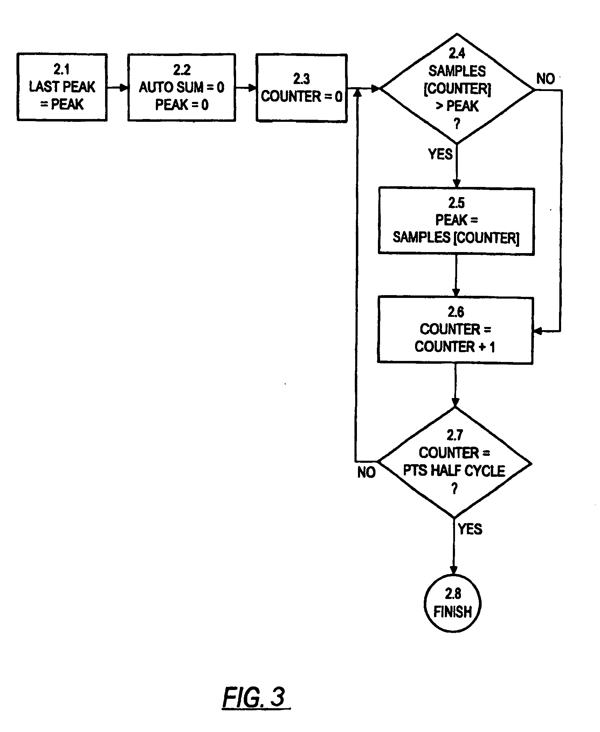

Turning now to FIG. 2, there is shown an overview flow chart of the steps accomplished by the arcing fault detection system according to one embodiment of the 3 present invention. Each of these steps will be described in detail in relation to FIGs. 3 through 7. Generally, however, step 1 represents the obtaining of current samples from the sampler 1528. Preferably, samples will be taken from either two consecutive half-cycles (e.g. a positive half-cycle followed by a negative half-cycle, or vice versa), two consecutive positive half-cycles or two consecutive negative half cycles. Moreover, it is preferred that samples are taken at 32 points per half cycle of current, but it will be appreciated that an alternate number of sampling points may be used. Next, as represented by step 2, the CPU determines the magnitude of the current peak in each selected half cycle. Next, as represented by step 3, the "slope", or ratio of current peaks from one half cycle to the next is assigned a polarity (e.g. "positive" or "negative"), and the number of reversals of polarity between adjacent slopes is counted.

Finally, in step 6, the number of reversals in polarity is compared to a trip threshold level. If the number of reversals in polarity exceed the trip threshold level, a trip signal is sent to the line interrupter 1522 to disconnect the power source from the load. If the number of reversals in polarity do not exceed the trip threshold level and thereby do not represent an arcing fault, the above-described process repeats itself with newly obtained current samples until an arcing fault is detected. Preferably, the trip threshold level will be high enough so that reversals in polarity caused by known load transients do not trip the circuit breaker. In a preferred embodiment of the present invention, the trip threshold level is based on finding fifteen or more reversals in polarity per second.

In another embodiment of the present invention, the CPU 1530 detects arcing faults by counting the number of significant waveform shape changes between half cycles in addition to counting the number of reversals in polarity. This is accomplished by performing step 3 heretofore described along with additional steps 4 and 5. In step 4, the CPU 1530 normalizes and autocorrelates the current samples. Normalizing is accomplished by dividing each of the current samples by the peak current associated with the half cycle from which they were taken. Each of the current samples will thereby have a normalized magnitude less than or equal to 1. Autocorrelation is accomplished by comparing each one of the number of normalized current samples from one half cycle to the corresponding one of the number of normalized current samples in the next selected half cycle. As will be described in more detail hereinafter, the autocorrelation step is designed to obtain a measure of significant waveform shape changes between selected half cycles. In steps 5 and 6, the CPU counts the number of significant shape changes occurring within a predetermined time interval and sends a trip signal to the line interrupter 1522 if the number of significant shape changes exceed a trip threshold level.

Similar to the trip threshold level associated with slope changes described above, the trip threshold level associated with shape changes will preferably be high enough so that significant shape changes caused by known load transients do not trip the circuit breaker. In a preferred embodiment of the present invention, the trip threshold level associated with shape changes is based on finding three significant shape changes per second. Thus, in a preferred embodiment of the present invention, the line interrupter may be triggered by fifteen or more reversals in polarity per second or three or more significant shape changes per second. It will be appreciated, however, that other trip thresholds and/or time intervals may be selected without departing from the scope of the present invention.

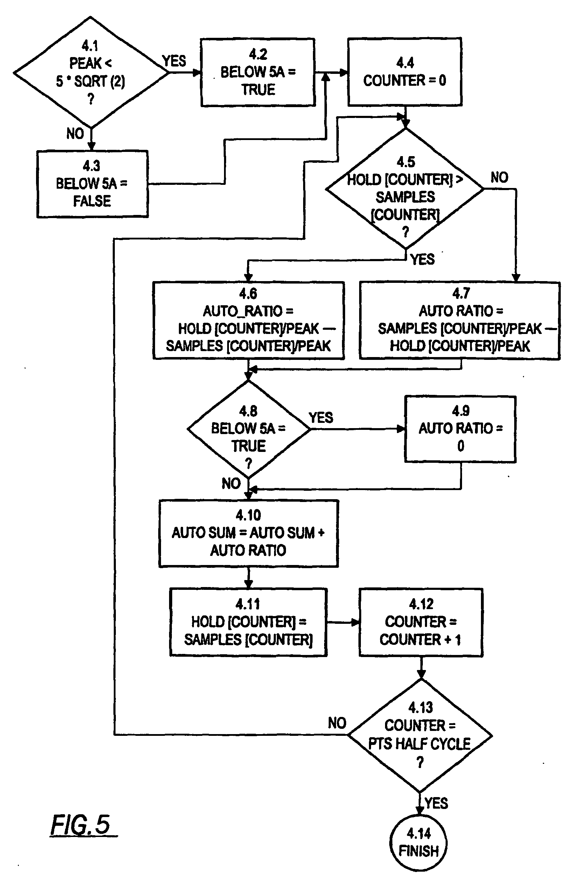

FIGs. 3 through 7 are flow charts representing the steps associated with the flowchart of FIG. 2 in greater detail. Referring initially to FIG. 3, there is shown a flow chart illustrating the peak detection subroutine associated with step 2 of the flowchart of FIG. 2. In step 2.1, the peak current of the most recent half cycle is stored in memory as variable "last peak". In step 2.2, an "auto sum" and a "peak" variable associated with the present half cycle are initialized to zero. The "auto sum" variable will be described hereinafter in relation to FIGs. 5 through 7. The "peak" variable represents the value of the current sample having the largest absolute magnitude in the present half cycle. An integer counter number is initialized to zero in step 23. In step 2.4, a current sample associated with the present counter number is compared to the value of the "peak" variable associated with the next most recent counter number in the present cycle. For example, in the 5th iteration of step 2.4, current sample 5 is compared to the "peak" variable obtained through current samples 1-4 of the present cycle. If the current sample associated with the counter number is greater than any of the previous current samples in the present cycle, the "peak" variable is reset to match the absolute magnitude of the current sample (step 2.5). The counter number is thereafter incremented by one (step 2.6) and, if the counter number is less than the number of points per half cycle (step 2.7), the process returns to step 2.4 with the next current sample. In step 2.4, if the current sample associated with the counter number is not greater than the previous "peak" variable, the process proceeds to step 2.6 and continues as heretofore described. In bypassing step 2.5, the "peak" variable is not reset but rather retains whatever value it had prior to the present current sample. Finally, in step 2.7, if the counter number equals the number of points in the half cycle, the process is complete. The value of the "peak" variable upon completion of the process thereby represents the absolute value of the peak t sample in its associated half cycle.

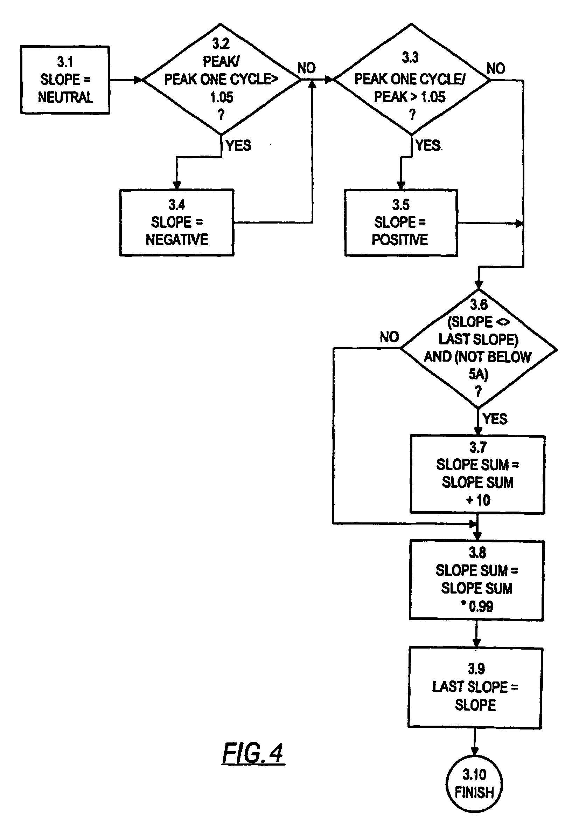

Turning now to FIG. 4, there is shown a flow chart illustrating the count slope changes subroutine associated with step 3 of the flowchart of FIG. 2. In step 3.1, a "slope" variable is initialized to neutral. The "slope" variable represents the slope of a line drawn from the current peak in a first selected half cycle (designated as variable "peak") to the current peak in a second selected half cycle (designated as variable "peak one cycle"). Preferably, the "peak" and "peak one cycle" variables represent the current peaks of consecutive positive (or negative) half cycles.

In steps 3.2 and 3.3, the current peaks in the selected half cycles are compared to each other to determine if they represent a significant slope change, defined here as being greater than 5%. More specifically, the ratio of "peak" to "peak one cycle" is evaluated in step 3.2. and the ratio of "peak one cycle" to "peak" is evaluated in step 33. If the ratio derived in step 3.2 is greater than 1.05, the slope variable is designated as negative (step 3.4). If the ratio derived in step 3.3 is greater than 1.05. the slope variable is designated as positive (step 3.5). If neither ratio is greater than 1.05. the slope remains designated as neutral.

In step 3.6, the slope direction associated with the selected pair of half cycles is compared to the slope direction of the next most recent pair of half cycles. A change in slope occurs when the slope directions change in polarity (e.g. from "positive" to "negative", or vice versa) and neither of the peaks is less than five amps. Current peaks of less than five amps are ignored because they do not represent a significant electrical hazard. If it is determined in step 3.6 that a change in slope has occurred, the slope change is counted in step 3.7 by incrementing a "slope sum" variable by an arbitrary number, here 10. In step 3.8, the "slope sum" variable is multiplied by 0.99 to decay the cumulative value of the "slope sum" variable by one percent at each sampling point of the waveform.

FIG. 5 is a flow chart illustrating the normalization and autocorrelation subroutines associated with step 4 in the flowchart of FIG. 2. Normalizing the current values before autocorrelating them enables the present invention to avoid a problem associated with the prior art, namely "false tripping" or erroneously indicating an arcing fault in response to load transients caused by, for example, the starting of an electrical motor. Because load transients cause changes in magnitude of the current between cycles, arc detection systems which indicate or at least conditionally indicate an arcing fault in responses to changes in magnitude in current are likely to false trip in response to the load transients. By normalizing the current values in every half cycle to a peak of "1", the arcing fault detection system according to the present invention is insensitive to increases in magnitude in current caused by load transients, and thereby is not likely to false trip in response to load transients.

In step 4.1, it is determined whether or not the "peak" variable has an rms value of less than 5 amps. If it is less than 5 amps, a boolean "Below 5A" variable is designated as True (step 4.2). If it is not less than 5 amps, the "Below 5A" variable is designated as False (step 43). An integer counter number is initialized to zero in step 4.4.

In step 4.5, the sampled current from a selected half cycle associated with the counter number (designated "samples[counter]") is compared to the sampled current from a previous half cycle associated with the same counter number (designated "hold[counter]"). For example, in the tenth iteration, sample "10" from the present half cycle is compared to the stored current sample "10" from the previous half cycle. Thereafter, in step 4.6 or 4.7, the current samples associated with the counter number in both the present cycle and previous cycle are normalized by dividing them by the peak current associated with the previous cycle, then subtracted from each other to obtain the difference between the normalized current from the present cycle to the previous half cycle. The smaller of the two normalized values is subtracted from the larger of the two normalized values so that the difference comprises a positive number representing the absolute value between the two normalized values. This result is designated by the variable "auto ratio".

In step 4.8, if the "Below 5A" variable is true, the "auto ratio" variable associated with the counter number is set to zero in step 4.9. In step 4.10, an "auto sum" variable, representing the cumulative sum of the ratios of corresponding current samples in selected half cycles, is incremented by the value of the "auto ratio" variable heretofore described. The "hold[counter]" variable associated with the counter number is then reset to the value of the "samples[counter]" variable associated with the counter number (step 4.11), and the counter number is incremented by one (step 4.12). If the counter number is less than the number of points per half cycle (step 4.13), the process returns to step 4.5 with the next current sample. The process is complete when the counter number equals the number of points in the half cycle. The value of the "auto sum" variable upon completion of the process thereby represents a measure of shape changes between selected half cycles.

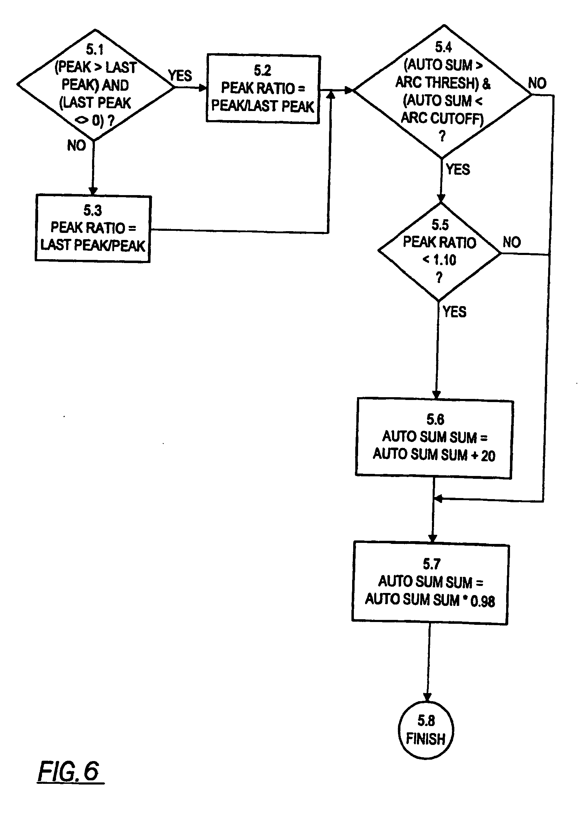

FIG. 6 is a flow chart illustrating the counting shape changes subroutine associated with step 5 in the flowchart of FIG. 2. In step 5.1, it is determined whether the "peak" variable is greater than the "last peak" variable and the "last peak" variable is not equal to zero. Thereafter, in step 5.2 or 5.3, the ratio of the present peak to the last peak (designated by variable "peak ratio") is computed. Next, in step 5.4, it is determined whether the "auto sum" variable described in relation to FIG. 5 is greater than an arc threshold value and less than an arc cutoff value. The arc threshold value, as previously described, is preferably based on detecting 16 significant waveform shape changes per second. The arc cutoff value is based on detecting an excessively large number of significant shape changes, which indicate load fluctuations rather than arcs. In step 5.5, it is determined whether the peak ratio is less than 1.10. If the answer in both steps 5.4 and 5.5 is determined to be yes, a significant shape change has occurred and an "auto sum sum" variable is incremented by an arbitrary number (here 20) in step 5.6. In step 5.7, the "auto sum sum" variable is multiplied by 0.98 to decay the cumulative value of the "auto sum sum" variable by two percent at each sampling point of the waveform.

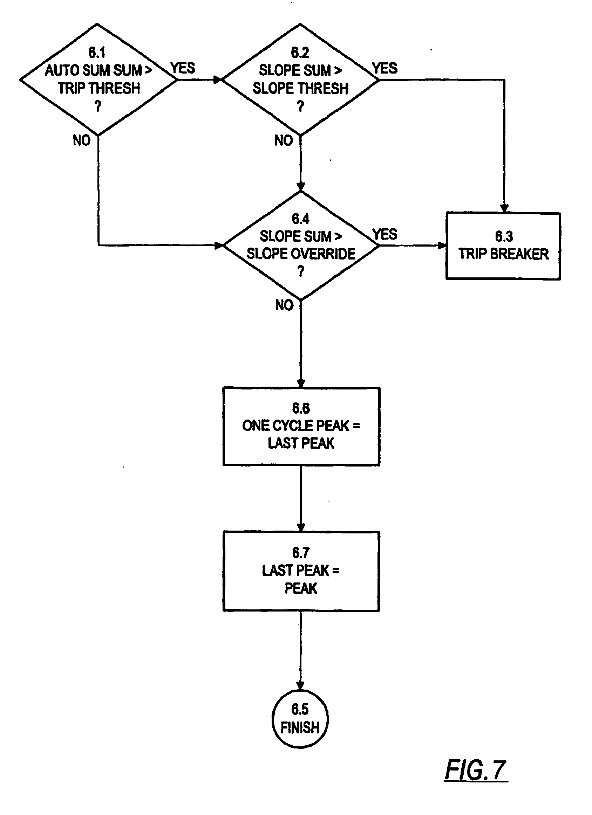

Now turning to FIG. 7, there is shown a flow chart illustrating the check for trip condition subroutine associated with step 6 in the flowchart of FlG. 2. If the number of significant shape changes represented by the "auto sum sum" variable is greater than a trip threshold level (step 6.1) and the number of slope changes represented by the "slope sum" variable is greater than a slope threshold level (step 6.2), a trip signal is generated to trip the circuit breaker (step 6.3). The circuit breaker is also tripped if the slope sum sum is greater than a slope override level (step 6.4). If neither of the trip conditions occur, the peak current of the most recent half cycles are stored in memory in steps 6.6 and 6.7, and the entire process of detecting arcing faults continues with subsequent half cycles.

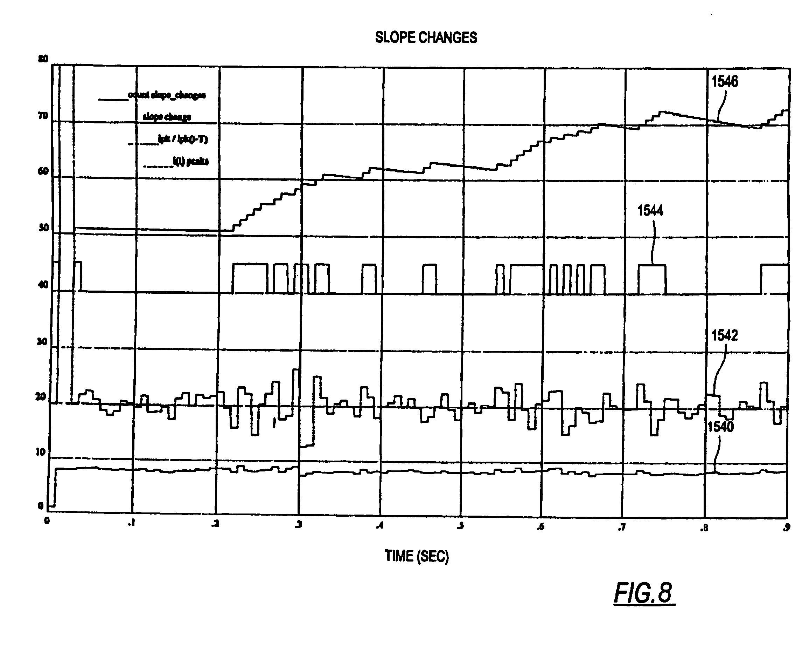

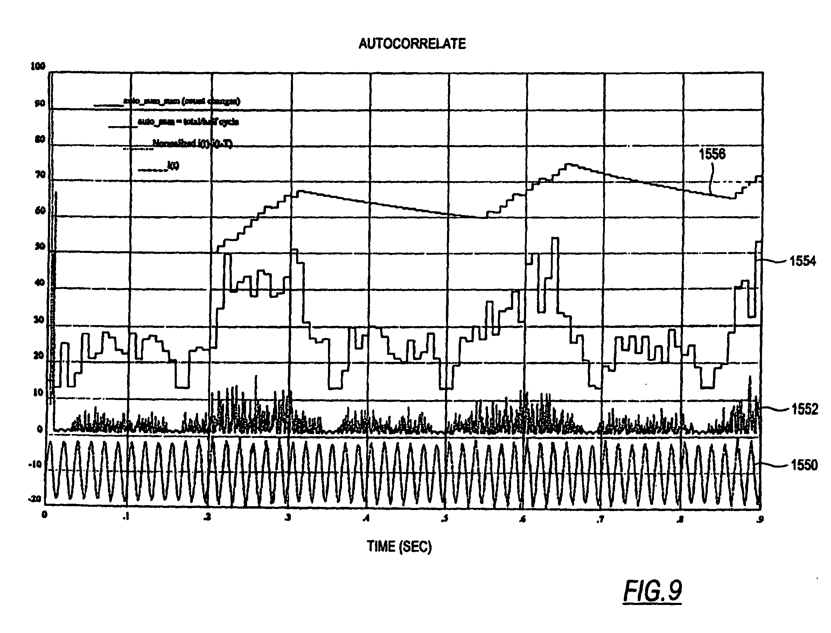

The subroutines described in relation to FIG. 3 through FIG. 7 may perhaps best be understood by reference to the series of waveforms shown in FIG. 8 and 9. FIG. 8 depicts the waveforms associated with the detection of slope changes and FIG. 9 depicts the waveforms associated with the detection of shape changes. Turning initially to FIG. 8, waveform 1540 represents the "peak" variable discussed in relation to FIG. 3. The "peak"variable represents the value of the current sample having the largest absolute magnitude in its associated half cycle. Thus, waveform 1540 is comprised of one discrete value per cycle, or 12 discrete values per every tenth of a second. As shown in FIG. 6, the "peak" waveform 1540 has a minimum value of zero amps (corresponding reference position "0" in FIG. 8) and a maximum value of about ten amps (corresponding to reference position "10" in FIG. 8).

Waveform 1542 represents the slope of the current peaks from one half cycle to the previous half cycle. As heretofore defined, the slope is computed by taking the ratio of the current peak in one half cycle to the current peak of the previous half cycle. The ratios falling above the line represent "positive" slopes and the ratios falling below the line represent "negative" slopes. The waveform 1542 is centered on zero percent (corresponding to reference position "20" in FIG. 8) and fluctuates between a minimum value of about minus two percent (corresponding to reference position "10'') and a maximum value of about plus two percent (corresponding to reference position "30").

Waveform 1544 comprises a series of pulses indicating whether the slopes of waveform 1542 have changed in polarity (e.g. from "positive" to "negative" or vice versa) from cycle to cycle. As described in relation to FIG. 4, slope changes are indicated only if the peak currents between cycles differ by at least 5% and if the peak current is not less than 5 amps rms. As shown in FIG. 8, the waveform 1544 comprises a series of binary zeros (corresponding to reference position "40") indicating that a slope change has not occurred and binary "ones" (corresponding to reference position "45") indicating that a slope change has occurred.

Waveform 1546 represents the "slope sum" variable described in relation to FIG. 4, comprising a count of significant slope changes from cycle to cycle. As shown in FIG. 8, the "slope sum" waveform 1546 has a minimum value of zero (corresponding to reference position "50") and a maximum value of about thirty (corresponding to reference position "80"). A first trip criteria for the arcing fault detection system is triggered when the "slope sum" variable 1546 equals or exceeds fifteen significant slope changes per second (corresponding to y-axis reference "65").

Now turning to FIG. 9, waveform 1550 represents the current i(t) on the line conductor, comprising an ac waveform at a frequency of 60 Hz throughout a time interval of 0.9 seconds. Each cycle has a period of 1/60th of a second, or 16.67 milliseconds. Accordingly, there are 6 full cycles (or 12 half cycles) every tenth of a second. The i(t) waveform is centered on zero amps (corresponding to y-axis reference "-10") and cycles between a minimum value of about minus 10 amps (corresponding to reference position "-20") and a maximum value of about plus 10 amps (corresponding to reference position "0").

Waveform 1552 represents the value of the "auto ratio" variable discussed in relation to FIG. 5. The "auto ratio" variable represents the differences between the normalized current from the sample position in one half cycle to that of the corresponding sample position in the previous half cycle, expressed as a percentage. The "auto ratio" waveform 1552 thereby represents a plurality of individual "auto ratio" variables, 32 per half cycle, corresponding to the number of samples taken of the i(t) waveform 1550. As shown in FIG. 9, the "auto ratio" waveform 1552 has a minimum value of zero percent (corresponding to reference position "0'') and a maximum value of about twenty percent (corresponding to reference position "10").

Waveform 1554 represents the "auto sum" variable. The "auto sum" variable is computed by summing the "auto ratio" waveform 1552 in each half cycle. Thus, the "auto sum" waveform 1554 provides a measure of the number of shape changes per half cycle, comprising one discrete value per half cycle, or 12 values for every tenth of a second. As shown in FIG. 9, the "auto sum" waveform 1554 has a minimum value of zero (corresponding to reference position "10") and a maximum value of about eight (corresponding to reference position "50").

Waveform 1556 represents the "auto sum sum" variable. As discussed above, the magnitude of the "auto sum sum" variable is dependent on whether the "auto sum" waveform 1554 is greater than an arc threshold value and less than an arc cutoff value, and whether the ratio of current peaks from cycle to cycle is less than 10%. If these conditions are satisfied, a significant shape change has occurred and the "auto sum sum" variable is incremented accordingly. As shown in FIG. 9, the "auto sum sum" waveform 1556 has a minimum value of zero (corresponding to reference position "50") and a maximum value of about twelve or thirteen (corresponding to reference position "75"). A second trip criteria for the arcing fault detection system is triggered when the "auto sum sum" variable 1556 equals or exceeds three significant shape changes per second (corresponding to reference position "56").

While particular embodiments and applications of the present invention have been illustrated and described, it is to be understood that the invention is not limited to the precise construction and compositions disclosed herein and that various modifications, changes, and variations will be apparent from the foregoing descriptions without departing from the scope of the invention as defined in the appended claims.

While the present invention has been described with reference to one or more particular embodiments, those skilled in the art will recognize that many changes may be made thereto without departing from the scope of the present invention. Such variations are contemplated as falling within the scope of the claimed invention, as set forth in the following claims.

## Claims

1. A method of detecting arcing faults in a line conductor carrying an electrical current between a power source and a load, said electrical current defining an AC waveform comprising a series of alternating positive half cycles and negative half cycles,
said method comprising the steps of:
(a) obtaining current samples in a series of half cycles of said waveform;
(b) determining a peak current, which is the value of the current sample having the largest absolute value, within each of the series of half cycles;
(c) comparing said peak currents of a selected pair of said half cycles to determine a slope direction, being the slope direction of a line drawn from the current peak in a first selected half cycle to the current peak in a second selected half cycle, between said selected pair of half cycles;
(d) counting a number of reversals in polarity, each reversal in polarity being a change in said slope direction from positive to negative or vice versa, occurring in a selected time interval, said reversals in polarity occurring when said slope direction between said selected pair of half cycles differs from said slope direction of a next selected pair of half cycles;
(e) generating an arc indicative signal when the number of said reversals in polarity occurring within said selected time interval equals or exceeds a predetermined threshold number.

2. The method of claim 1 wherein the selected pair of half cycles comprises two consecutive half cycles.

3. The method of claim 1 or 2 wherein the selected pair of half cycles comprises two consecutive negative half cycles.

4. The method of claim 1 or 2 wherein the selected pair of half cycles comprises two consecutive positive half cycles.

5. The method of claim 1 wherein step (d) comprises counting only the number of said reversals in polarity in which said peak current of a second of said selected pair of half cycles is at least five amps.

6. The method of claim 1 wherein step (d) comprises counting only the number of said reversals in polarity in which said peak currents of said selected pair of half cycles differ by at least five percent.

7. The method of claim 1 wherein the selected time interval is one second and the predetermined threshold number is fifteen.

8. The method of any of claims 1 - 7 further comprising the steps of:
(a) normalizing each of the current samples, which is the process of dividing each of the current samples by said peak current associated with the half cycle from which it was taken,;
(b) auto correlating, which is the process of comparing each one of the number of normalized current samples from one half cycle to the corresponding one of the number of normalized current samples in the next selected half cycle, said normalized current samples to obtain a measure of significant waveform shape changes between the selected half cycles;
(c) counting a number of significant waveform shape changes occurring within said selected time interval.

9. The method of claim 8 wherein step (b) comprises:
computing the differences between the normalized current samples of said selected pair of half cycles;
summing the absolute values of the differences between the normalized current samples of said selected pair of half cycles; and
evaluating the summed absolute values in relation to a third predetermined threshold to determine whether the summed absolute values represent a significant waveform shape change between said selected pair of half cycles.

10. The method of claim 8 wherein the selected time interval is one second, the first predetermined threshold number is fifteen and the second predetermined threshold number is three.

11. The method of claim 8 wherein the step of counting a number of said reversals in polarity comprises counting only the number of said reversals in polarity in which said peak current of a second of said selected pair of half cycles is at least five amps.

12. The method of claim 8 wherein the step of counting a number of said reversals in polarity, comprises counting only the number of said reversals in polarity in which said peak currents of said selected pair of half cycles differ by at least five percent.

## Patentansprüche

1. Verfahren zum Erfassen von Lichtbogenfehlern in einem Leitungs-Leiter, der einen elektrischen Strom zwischen einer Stromversorgungsquelle und einer Last führt,
wobei der elektrische Strom eine Wechselstrom-Wellenform definiert, die eine Reihe wechselnder positiver Halbzyklen und negativer Halbzyklen aufweist,
wobei das Verfahren die Schritte aufweist:
(a) Erhalten von Stromabtastungen in einer Reihe von Halbzyklen der Wellenform;
(b) Bestimmen eines Peak-Stroms, der der Wert der Stromabtastung, die den größten absoluten Wert besitzt, innerhalb jeder der Reihen von Halbzyklen ist;
(c) Vergleichen der Peak-Ströme eines ausgewählten Paars der Halbzyklen, um eine Neigungsrichtung zu bestimmen, die die Neigungsrichtung eine Linie ist, die von dem Strom-Peak in einem ersten ausgewählten Halbzyklus zu dem Strom-Peak in einem zweiten ausgewählten Halbzyklus zwischen dem ausgewählten Paar von Halbzyklen gezogen ist;
(d) Zählen einer Zahl von Umkehrungen in der Polarität, wobei jede Umkehrung in der Polarität eine Änderung in der Neigungsrichtung von positiv zu negativ oder vice versa ist, die in einem ausgewählten Zeitintervall auftritt, wobei die Umkehrungen in der Polarität dann auftreten, wenn sich die Neigungsrichtung zwischen dem ausgewählten Paar von Halbzyklen von der Neigungsrichtung eines nächsten ausgewählten Paars von Halbzyklen unterscheidet;
(e) Erzeugen eines für einen Lichtbogen indikativen Signals, wenn die Zahl der Umkehrungen in der Polarität, die innerhalb des ausgewählten Zeitintervalls auftritt, gleich einer vorbestimmten Schwellwertzahl ist oder diese übersteigt.

2. Verfahren nach Anspruch 1, wobei das ausgewählte Paar von Halbzyklen zwei aufeinander folgende Halbzyklen aufweist.

3. Verfahren nach Anspruch 1 oder 2, wobei das ausgewählte Paar von Halbzyklen zwei aufeinander folgende negative Halbzyklen, aufweist.

4. Verfahren nach Anspruch 1 oder 2, wobei das ausgewählte Paar von Halbzyklen zwei aufeinander folgende positive Halbzyklen aufweist.

5. Verfahren nach Anspruch 1, wobei der Schritt (d) ein Zählen nur der Zahl der Umkehrungen in der Polarität, in der der Peak-Strom eines zweiten des ausgewählten Paars von Halbzyklen mindestens fünf Ampere beträgt, aufweist.

6. Verfahren nach Anspruch 1, wobei der Schritt (d) ein Zählen nur der Zahl der Umkehrungen in der Polarität, in der sich die Peak-Ströme des ausgewählten Paars von Halbzyklen um mindestens fünf Prozent unterscheiden, aufweist.

7. Verfahren nach Anspruch 1, wobei das ausgewählte Zeitintervall eine Sekunde beträgt und die vorbestimmte Schwellwertzahl fünfzehn ist.

8. Verfahren nach einem der Ansprüche 1 - 7, das weiterhin die Schritte aufweist:
(a) Normieren jeder der Stromabtastungen, was der Vorgang eines Teilens jeder der Stromabtastungen durch den Peak-Strom ist, der dem Halbzyklus zugeordnet ist, von dem er genommen wurde;
(b) Durchführen einer Autokorrelation, was der Vorgang eines Vergleichens jeder einen der Zahl normierter Stromabtastungen von einem Halbzyklus zu dem entsprechenden einen der Zahl normierter Stromabtastungen in dem nächsten ausgewählten Halbzyklus ist, wobei die normierten Stromabtastungen dazu dienen, ein Maß signifikanter Wellenformänderungen zwischen den ausgewählten Halbzyklen zu erhalten;
(c) Zählen einer Zahl signifikanter Wellenformänderungen, die innerhalb des ausgewählten Zeitintervalls auftreten.

9. Verfahren nach Anspruch 8, wobei der Schritt (b) aufweist:
Berechnen der Differenzen zwischen den normierten Stromabtastungen des ausgewählten Paars von Halbzyklen;
Aufsummieren der absoluten Werte der Differenzen zwischen den normierten Stromabtastungen des ausgewählten Paars von Halbzyklen; und
Bewerten der aufsummierten, absoluten Werte in Bezug auf einen dritten vorbestimmten Schwellwert, um zu bestimmen, ob die aufsummierten, absoluten Werte eine signifikante Wellenformänderung zwischen dem ausgewählten Paar von Halbzyklen darstellen.

10. Verfahren nach Anspruch 8, wobei das ausgewählte Zeitintervall eine Sekunde beträgt, die erste vorbestimmte Schwellwertzahl fünfzehn ist und die zweite vorbestimmte Schwellwertzahl drei ist.

11. Verfahren nach Anspruch 8, wobei der Schritt eines Zählens einer Zahl der Umkehrungen in der Polarität ein Zählen nur der Zahl der Umkehrungen in der Polarität umfasst, in der der Peak-Strom eines zweiten des ausgewählten Paars von Halbzyklen mindestens fünf Ampere ist.

12. Verfahren nach Anspruch 8, wobei der Schritt eines Zählens einer Zahl der Umkehrungen in der Polarität ein Zählen nur der Zahl der Umkehrungen in der Polarität umfasst, in der sich die Peak-Ströme des ausgewählten Paars von Halbzyklen um mindestens fünf Prozent unterscheiden.

## Revendications

1. Procédé pour détecter des arcs électriques dans un conducteur de ligne portant un courant électrique entre une source d'énergie et une charge, ledit courant électrique définissant une forme d'onde de courant alternatif comprenant une série de demi-périodes positives et de demi-périodes négatives alternées,
ledit procédé comprenant les étapes :
(a) d'obtention d'échantillons de courant dans une série de demi-périodes de ladite forme d'onde ;
(b) de détermination d'un courant de crête, qui est la valeur de l'échantillon de courant ayant la valeur absolue la plus grande, à l'intérieur de chaque série de demi-périodes ;
(c) de comparaison desdits courants de crête d'une paire sélectionnée desdites demi-périodes pour déterminer une direction de pente, étant la direction de la pente d'une ligne dessinée depuis la crête de courant dans une première demi-période sélectionnée jusqu'à la crête de courant dans une seconde demi-période sélectionnée, entre ladite paire sélectionnée de demi-périodes ;
(d) de comptage d'un nombre d'inversions de polarité, chaque inversion de polarité étant une variation de ladite direction de pente du positif au négatif, ou vice versa, se produisant dans un intervalle de temps sélectionné, lesdites inversions de polarité se produisant lorsque ladite direction de pente entre ladite paire sélectionnée de demi-périodes diffère de ladite direction de pente d'une paire sélectionnée suivante de demi-périodes ;
(e) de génération d'un signal indiquant un arc lorsque le nombre desdites inversions de polarité se produisant dans ledit intervalle sélectionné est égal ou supérieur à un nombre seuil prédéterminé.

2. Procédé selon la revendication 1, dans lequel la paire sélectionnée de demi-périodes comprend deux demi-périodes consécutives.

3. Procédé selon la revendication 1 ou 2, dans lequel la paire sélectionnée de demi-périodes comprend deux demi-périodes négatives consécutives.

4. Procédé selon la revendication 1 ou 2, dans lequel la paire sélectionnée de demi-périodes comprend deux demi-périodes positives consécutives.

5. Procédé selon la revendication 1, dans lequel l'étape (d) comprend le comptage uniquement du nombre desdites inversions de polarité où ledit courant de crête d'une seconde de ladite paire sélectionnée de demi-périodes est d'au moins cinq ampères.

6. Procédé selon la revendication 1, dans lequel l'étape (d) comprend le comptage uniquement du nombre desdites inversions de polarité où lesdits courants de crête de ladite paire sélectionnée de demi-périodes diffèrent d'au moins cinq pour cent.

7. Procédé selon la revendication 1, dans lequel l'intervalle de temps sélectionné est une seconde et le nombre seuil prédéterminé est quinze.

8. Procédé selon l'une quelconque des revendications 1 à 7 comprenant en outre les étapes :
(a) de normalisation de chacun des échantillons de courant, qui est le processus visant à diviser chacun des échantillons de courant par ledit courant de crête associé à la demi-période de laquelle il provient ;
(b) d'autocorrélation desdits échantillons de courant normalisés, qui est le processus visant à comparer chacun du nombre d'échantillons de courant normalisés d'une demi-période avec celui correspondant parmi le nombre d'échantillons de courant normalisés dans la demi-période sélectionnée suivante, afin d'obtenir une mesure de variations significatives de profil de forme d'onde entre les demi-périodes sélectionnées ;
(c) de comptage d'un nombre de variations significatives de profil de forme d'onde se produisant dans ledit intervalle de temps sélectionné.

9. Procédé selon la revendication 8, dans lequel l'étape (b) comprend :
le calcul des différences entre les échantillons de courant normalisés de ladite paire sélectionnée de demi-périodes ;
l'addition des valeurs absolues des différences entre les échantillons de courant normalisés de ladite paire sélectionnée de demi-périodes ; et
l'évaluation des valeurs absolues additionnées par rapport à un troisième seuil prédéterminé afin de déterminer si les valeurs absolues additionnées représentent une variation significative de profil de forme d'onde entre ladite paire sélectionnée de demi-périodes.

10. Procédé selon la revendication 8, dans lequel l'intervalle de temps sélectionné est une seconde, le premier nombre seuil prédéterminé est quinze et le second nombre seuil prédéterminé est trois.

11. Procédé selon la revendication 8, dans lequel l'étape de comptage d'un nombre desdites inversions de polarité comprend le comptage uniquement du nombre desdites inversions de polarité dans lesquelles ledit courant de crête d'une seconde de ladite paire sélectionnée de demi-périodes est d'au moins cinq ampères.

12. Procédé selon la revendication 8, dans lequel l'étape de comptage d'un nombre desdites inversions de polarité comprend le comptage uniquement du nombre desdites inversions de polarité dans lesquelles lesdits courants de crête de ladite paire sélectionnée de demi-périodes diffèrent d'au moins cinq pour cent.
